Europäisches Patentamt

**European Patent Office**

**Office européen des brevets**

(19)

(11) Veröffentlichungsnummer: **0 108 194**
**B1**

(12) **EUROPÄISCHE PATENTSCHRIFT**

(45) Veröffentlichungstag der Patentschrift:
**28.01.87**

(51) Int. Cl.⁴: **H 03 F 3/26**

(21) Anmeldenummer: **83106766.5**

(22) Anmeldetag: **09.07.83**

(54) Schaltungsanordnung für einen selektiven Gegentaktverstärker.

(30) Priorität: **20.07.82 DE 3227109**

(43) Veröffentlichungstag der Anmeldung:
**16.05.84 Patentblatt 84/20**

(45) Bekanntmachung des Hinweises auf die Patenterteilung:
**28.01.87 Patentblatt 87/5**

(84) Benannte Vertragsstaaten:
**AT BE CH DE FR GB IT LI NL SE**

(56) Entgegenhaltungen:
**DE - B - 1 589 840**
**US - A - 3 009 112**
**US - A - 3 092 753**
**US - A - 3 217 266**
**US - A - 3 388 337**
**US - A - 3 638 130**

**ELEKTRONIK, Nr. 11, 1981 F. LAMPE**
**"Leistungstransistoren in Kurzwellen- und**
**VHF/UHF-Anwendungen", Seiten 55-61**

(73) Patentinhaber: **MED-Inventio AG, Seestrasse 359,**
**CH-8038 Zürich-Wollishofen (CH)**

(72) Erfinder: **Flachenecker, Gerhard, Prof. Dr.-Ing., Bozener**
**Strasse 2, D-8012 Ottobrunn (DE)**
Erfinder: **Fastenmeier, Karl, Prof. Dr.-Ing., Lützelsteiner**
**Strasse 7 b, D-8000 München 45 (DE)**
Erfinder: **Lindenmeier, Heinz, Prof. Dr.-Ing.,**
**Fürstenrieder Strasse 7, D-8033 Planegg (DE)**

(74) Vertreter: **Wenzel, Joachim, Dipl.-ing.,**
**Hauptmannsreute 46, D-7000 Stuttgart 1 (DE)**

## Beschreibung

Die Erfindung bezieht sich auf eine Schaltungsanordnung entsprechend dem Oberbegriff des Anspruchs 1.

Gegentaktverstärker bestehen aus zwei Verstärkerdreipolen mit gleicher Betriebsspannungspolarität, deren Steuerelektroden gegenphasig angesteuert werden und deren Ausgangsströme über eine Ausgangsinduktivität zusammengefasst sind, wobei die Ausgangsinduktivität zugleich der Betriebsspannungsversorung für die Verstärkerdreipole dient, siehe z.B. US-A-3 009 112. Als «zwei Verstärkerdreipole gleicher Betriebsspannungspolarität» sind zum Beispiel zwei Elektronenröhren zu verstehen, die immer mit positiver Anodenspannung betrieben werden müssen. Weitere Beispiele sind zwei pnp-Transistoren, die beide mit negativer, oder zwei npn-Transistoren, die beide mit positiver Kollektor-Emitterspannung zu betreiben sind. In ähnlicher Weise sind alle anderen elektronischen Verstärkerelemente, wie zum Beispiel die verschiedenen Arten von Feldeffekttransistoren, zu sehen. Wegen der gleichen Betriebsspannungspolarität der beiden Verstärkerdreipole haben auch die Betriebsströme der beiden Verstärkerdreipole gleiche Polarität. Diese müssen daher am Ausgang des Verstärkers gegenphasig zusammengefasst werden, um sie für den Verbraucher in der richtigen Phasenlage zu überlagern. Diesem Zweck dient eine Ausgangsinduktivität oder ein Ausgangsübertrager, die in bekannter Weise eine magnetische Zusammenfassung der Ausgangsströme der beiden Verstärkerdreipole durchführen. Zur Betriebsspannungszuführung für die beiden Verstärkerdreipole dient in bekannter Weise ein Mittelabgriff an der Ausgangsinduktivität oder der Primärwicklung des Ausgangsübertragers.

Die Verstärkerdreipole können in jeder der drei bekannten Grundschaltungen betrieben werden. Für das Beispiel eines bipolaren Transistors wären dies die Emitter-, Basis- und Kollektorschaltung. In jeder dieser Schaltungen ist eine Steuerelektrode (z.B. die Basis in der Emitterschaltung des bipolaren Transistors) und eine Ausgangselektrode (z.B. der Kollektor in der Emitterschaltung des bipolaren Transistors) des Verstärkerdreipols definiert. Für die Verstärkerdreipole ist auch jede bekannte Variante der drei Grundschaltungen denkbar, wie zum Beispiel die Emitterschaltung mit Emitterwiderstand zur Stromgegenkopplung.

Verstärker werden im allgemeinen nach der Aussteuerungsart ihrer Verstärkerdreipole (z.B. Röhre, Transistor, FET) in Klassen eingeteilt. Aus der Literatur (siehe z.B. MEINKE-GUNDLACH, Taschenbuch der Hochfrequenztechnik, 3. Auflage, Springer-Verlag: Kapitel O, Senderverstärker und Neutralisation) sind A-, B- und C-Verstärker bekannt. Diese Einteilungen gelten für Breitbandverstärker und selektive (Schmalband-)Verstärker sowohl im Eintakt als auch im Gegentaktbetrieb (siehe z.B. auch H. SCHRÖDER, Elektrische Nachrichtentechnik, Verlag für Radio-Foto-Kinotechnik, Berlin: II. Band, Kapitel BIII/9, Gegentaktschaltungen). Die folgenden Ausführungen beschränken sich entsprechend dem Oberbegriff des Anspruchs 1 auf Gegentaktverstärker.

Die drei Verstärkerklassen unterscheiden sich in ihrem Verhalten hauptsächlich hinsichtlich
 – des erzielbaren Wirkungsgrades und
 – der auftretenden nichtlinearen Verzerrungen.

Beim A-Verstärker ist der Wirkungsgrad $\eta$ immer kleiner als 50%. Dafür sind die nichtlinearen Verzerrungen am kleinsten. Der geringe Wirkungsgrad ist darauf zurückzuführen, dass die Verstärkerdreipole zu jeder Zeit Strom führen und deswegen in den Verstärkerdreipolen in jedem Zeitmoment eine Verlustleistung entsteht.

Demgegenüber wird beim B-Verstärker eine Halbwellenansteuerung verwendet. Dadurch ist abwechselnd jeder Verstärkerdreipol immer eine Halbperiode der Momentanfrequenz stromfrei. In diesen Zeiten, in denen nur Spannung an dem betreffenden Verstärkerdreipol ansteht, aber kein Strom durch ihn fliesst, wird in ihm keine Verlustleistung erzeugt. Der Wirkungsgrad $\eta$ kann damit bis auf maximal 78.5% erhöht werden. Gegenüber dem A-Verstärker weist der B-Verstärker jedoch bekanntlich höhere nichtlineare Verzerrungen auf.

Beim C-Verstärker wird schliesslich die Ansteuerung der Verstärkerdreipole auf Bruchteile einer halben Periodendauer der Momentanfrequenz beschränkt. Dadurch werden die stromführenden Zeiten für die Verstärkerdreipole gegenüber dem B-Verstärker noch verkürzt und die Verlustleistung in den Verstärkerdreipolen wird weiter reduziert. In den nun sehr kurzen stromführenden Phasen müssen die Verstärkerdreipole allerdings deutlich höhere Ströme führen als beim A- oder B-Verstärker. Im Extremfall würde die stromführende Phase der Verstärkerdreipole auf die Zeit Null reduziert werden. Dann könnte der Wirkungsgrad zwar theoretisch 100% werden, aber die Verstärkerdreipole müssten unendlich hohe Stromimpulse in unendlich kurzer Zeit liefern. Bei jeder technischen Realisierung sind diese Extremwerte nicht erreichbar.

Es ist daher bekannt, dass beim C-Verstärker jede Annäherung an einen Wirkungsgrad von 100% mit einer zunehmenden, sehr starken Überhöhung der Spitzenströme in den Verstärkerdreipolen gegenüber den vom Verstärker wirklich zu liefernden Ausgangsströmen erkauft werden muss. Dies erfordert stark überdimensionierte Bauelemente, die dann wegen der geforderten kurzen Schaltzeiten meistens sehr teuer sind und keine wirtschaftlich günstige Lösung zulassen.

Ausserdem wachsen in Stromimpulsen mit abnehmender Zeitdauer und dafür steigender Amplitude die Anteile der harmonischen Frequenzen. Eine Wirkungsgradsteigerung führt daher beim C-Verstärker zusätzlich zu einer weiteren Erhöhung der nichtlinearen Verzerrungen in Form von Nebenwellen, bzw. steigendem Klirrfaktor. Dieser Effekt kann nur durch verstärktes Ausfiltern der Harmonischen verringert werden. Dem steht jedoch entgegen, dass bei einer Erhöhung der Filterwirkung, also zum Beispiel einer Verringerung der Bandbreite, die Filterverluste steigen und damit der Wirkungsgrad der Schaltung wieder kleiner wird.

Die bekannten A-, B- und C-Verstärker sind daher nicht in der Lage, hohen Wirkungsgrad und kleinstmögliche Verzerrungen gleichzeitig zu verwirklichen. Es sind jedoch viele Anwendungen bekannt, bei denen beide Anforderungen gleichzeitig auftreten. Zum Beispiel ist man bei Sendeverstärkern wegen der bei Sendern geforderten hohen Nebenwellendämpfung auf kleinstmögliche nichtlineare Verzerrungen angewiesen. Andererseits sollte aber auch der Wirkungsgrad so hoch wie möglich sein, damit bei einer grossen Sendeausgangsleistung die Verlustleistung so klein wie möglich bleibt. Da beide Forderungen von keiner der bekannten Verstärkerschaltungen gemeinsam erfüllt werden können, muss im allgemeinen ein niedriger Wirkungsgrad zugunsten ausreichend kleiner nichtlinearer Verzerrungen hingenommen werden.

Der Erfindung liegt die Aufgabe zugrunde, eine Schaltungsanordnung für einen selektiven Gegentaktverstärker zu schaffen, mit der hoher Wirkungsgrad und geringe nichtlineare Verzerrungen gleichzeitig erzielt werden. Weiterhin soll mit der Erfindung der beschriebene Nachteil der bisher bekannten Verstärker vermieden werden, dass bei Dimensionierung auf hohen Wirkungsgrad (Klasse-C-Verstärker) von den Verstärkerdreipolen sehr kurze Stromimpulse mit sehr hohen Spitzenwerten geliefert werden müssen, was zu einer zwangsläufigen Überdimensionierung der Verstärkerdreipole hinsichtlich Strombelastbarkeit und Abschaltverhalten und damit zu teueren Bauelementen führt.

Zur Lösung dieser Aufgabe werden erfindungsgemäss die in den Kennzeichen der Ansprüche angegebenen Massnahmen vorgeschlagen.

Bei der erfindungsgemässen Schaltungsanordnung sind zwischen die Ausgangselektroden der beiden Verstärkerdreipole und die Anschlüsse der Ausgangsinduktivität zwei Wicklungen eines aus drei Wicklungen bestehenden Übertragers geschaltet. Dabei sind diese beiden Wicklungen bezüglich ihrer Anschlüsse an den Ausgangselektroden der Verstärkerdreipole bzw. an der Ausgangsinduktivität mit entgegengesetztem Wicklungssinn versehen. Die dritte Wicklung dieses Übertragers ist mit einem Serienschwingkreis aus einer Induktivität und einer Kapazität solcher Dimensionierung beschaltet, dass sich im Stromkreis dieser dritten Wicklung zusammen mit der Streuinduktivität des Übertragers eine Serienresonanz ergibt, die etwa der mittleren Betriebsfrequenz des selektiven Verstärkers entspricht. Die dritte Wicklung stellt daher zusammen mit ihrer äusseren Beschaltung für den Übertrager einen Kurzschluss auf der mittleren Betriebsfrequenz des Verstärkers dar und verhindert im magnetischen Fluss des Übertragers alle Frequenzkomponenten, die im Frequenzbereich der Serienresonanz der dritten Übertragerwicklung, also im Bereich der mittleren Betriebsfrequenz des Verstärkers liegen. Im Bereich der mittleren Betriebsfrequenz zeigt daher der Übertrager an seiner ersten und seiner zweiten Wicklung eine niedrige Impedanz, die im Idealfall als Kurzschluss betrachtet werden kann. Wegen des gegenphasigen Anschlusses der ersten und der zweiten Wicklung zeigt der Übertrager auch niederohmiges Verhalten für alle Frequenzkomponenten der Differenz aus den Ausgangsströmen der beiden Verstärkerdreipole, die im Bereich der mittleren Betriebsfrequenz des Verstärkers liegen. Wenn also die beiden Verstärkerdreipole beispielsweise so angesteuert sind, dass sie jeweils einen gegenphasigen Sinus-Halbwellenstrom gleicher Polarität führen, so ergänzen sich diese Sinus-Halbwellen in der Differenz zu einem Sinusstrom der Betriebsfrequenz, der den Übertrager unbeeinflusst passiert. Für alle anderen Frequenzen, insbesondere auch die Vielfachen der mittleren Betriebsfrequenz des Verstärkers, ist der Stromkreis, dem die dritte Wicklung des Übertragers angehört, hochohmig. Für diese Frequenzen zeigen auch die beiden ersten Wicklungen des Übertragers hochohmiges Verhalten. Der Übertrager verhindert daher, dass in der Differenz der Ausgangsströme der beiden Verstärkerdreipole andere Frequenzen als ungefähr die Betriebsfrequenz des Verstärkers enthalten sind. Mit anderen Worten, der Übertrager erzwingt, dass die Differenz der Ausgangsströme der beiden Verstärkerdreipole sinusförmig ist.

Der erzwungene Sinusstrom in der Differenz der Ausgangsströme fliesst auch dann, wenn die Verstärkerdreipole jeweils für eine Halbperiode vollständig auf Durchlass gesteuert werden, also im Gegentakt für jeweils eine Halbperiode der Betriebsfrequenz einen Kurzschluss darstellen. Die Spannung an den Vestärkerdreipolen ist dann in den betreffenden Halbperioden nahezu null. Werden die Verstärkerdreipole in der jeweils anderen Hälfte der Periodendauer vollständig auf Sperren gesteuert, so kann in dieser Zeit kein Strom durch den jeweils betroffenen Verstärkerdreipol fliessen. Damit ist der Zustand erreicht, dass die beiden Verstärkerdreipole jeweils nur für eine Halbperiode einen fast exakten Sinus-Halbwellenstrom führen, während in der gleichen Halbperiode an diesem Verstärkerdreipol keine Spannung ansteht, also keine Verlustleistung umgesetzt wird. In der jeweils anderen Halbperiode ist der betreffende Verstärkerdreipol gesperrt. Solange also Spannung am Verstärkerdreipol ansteht, fliesst kein Strom. Damit wird auch in dieser Halbperiode keine Verlustleistung erzeugt.

In der Ausgangsinduktivität werden die beiden Sinus-Halbwellen zu einer extrem verzerrungsarmen Sinusschwingung zusammengefügt.

Ein weiterer Vorteil der Schaltungsanordnung ist es, dass die Strombelastung der Verstärkerdreipole nur gerade so gross ist wie der geforderte Ausgangsstrom des Verstärkers. Stromimpulse mit überhöhten Amplituden, wie beim C-Verstärker, treten nicht auf. Ebenfalls ein Vorteil dieser Schaltungsanordnung sind die vereinfachten Schaltanforderungen an die verwendeten Verstärkerdreipole. Im Moment des Abschaltens, also am Ende der stromführenden Halbperiode des betroffenen Verstärkerdreipols, geht der Strom von dem Übertrager erzwungen durch Null. Damit spielen Speichereffekte und Abschaltverzögerungen, wie sie z.B. bei bipolaren Transistoren bekannt sind, eine untergeordnete Rolle.

Die vorangegangene Erläuterung bezieht sich auf ideale Verhältnisse, also auf einen streufreien und verlustlosen Übertrager, verlustlose Blindelemente im Serienschwingkreis und ideal steuerbare Verstärkerdreipole. In der Praxis kann nur mit realen Elementen gerechnet werden. Dies führt bei praktischen Realisierungen der Schaltungsanordnung dazu, dass nicht absolute Verlustlosigkeit und Verzerrungsfreiheit der Schaltung erreicht wird. Insgesamt erhält man jedoch viel kleinere Verluste und Verzerrungen als bei einem C-Verstärker.

Weitere vorteilhafte Ausgestaltungen der Erfindung ergeben sich aus den kennzeichnenden Merkmalen der abhängigen Ansprüche. Zur Ankopplung einer Lastimpedanz kann es vorteilhaft sein, die Ausgangsinduktivität mit einer zusätzlichen Wicklung zu einem Ausgangsübertrager zu ergänzen. Weiterhin können die nichtlinearen Verzerrungen des selektiven Gegentaktverstärkers weiter reduziert werden, wenn die Ausgangsinduktivität oder die Primärwicklung des Ausgangsübertragers oder die Sekundärwicklung des Ausgangsübertragers mit einem Kondensator solcher Dimensionierung zu einem Parallelresonanzkreis ergänzt sind, dass die Resonanzfrequenz dieses Resonanzkreises etwa der mittleren Betriebsfrequenz des Verstärkers entspricht.

Wird die Ausgangsinduktivität oder die Primärwicklung des Ausgangsübertragers oder die Sekundärwicklung des Ausgangsübertragers zusammen mit einem Kondensator als Parallelresonanzkreis betrieben, so ergibt sich eine besonders vorteilhafte Ausgestaltung der Erfindung, wenn dieser Kondensator so dimensioniert ist, dass in ihm bei der mittleren Betriebsfrequenz des Verstärkers etwa die gleiche Blindleistung umgesetzt wird, wie in dem Kondensator, der zusammen mit der Serieninduktivität und der Streuinduktivität des erfindungsgemässen Übertragers eine Serienresonanz etwa bei der mittleren Betriebsfrequenz des Verstärkers erzeugt. Bei dieser Dimensionierung zeigt die Schaltungsanordnung innerhalb des Durchlassbereiches des Verstärkers besonders frequenzunabhängiges Verhalten. Ausserdem gehen bei dieser Dimensionierung Toleranzen der Bauteile am wenigsten in das beschriebene Verhalten der Schaltungsanordnung ein.

Die Vorteile der Schaltungsanordnung werden besonders deutlich, wenn die Verstärkerdreipole im Gegentakt abwechselnd für je etwa eine Hälfte der Periodendauer der momentanen Betriebsfrequenz vollständig leitend und in der jeweils anderen Hälfte sperrend sind. Dies kann durch geeignete Wahl der Ansteuerspannungen für die Verstärkerdreipole in an sich bekannter Weise erreicht werden. Die Ansteuerspannungen für die Verstärkerdreipole können dabei zum Beispiel ungefähr rechteckigen oder ungefähr sinusförmigen Verlauf haben.

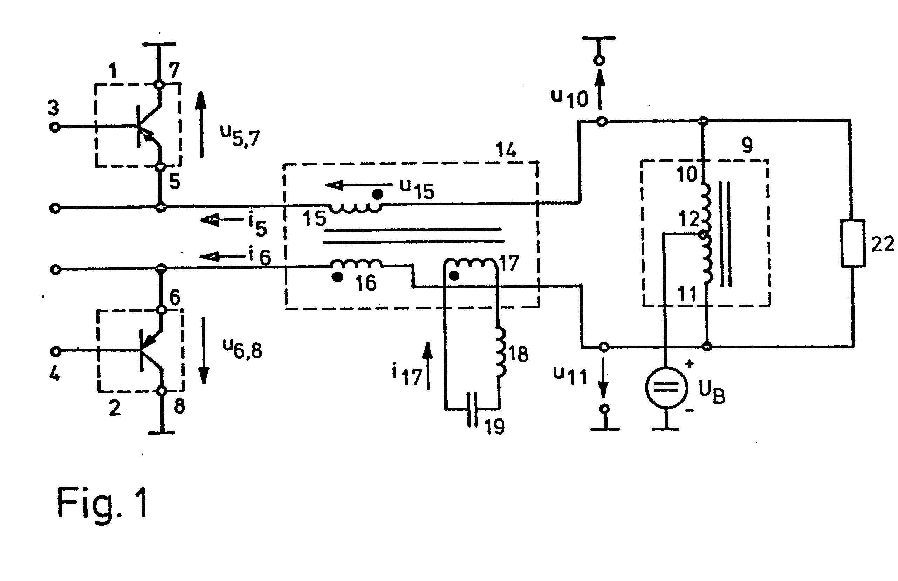

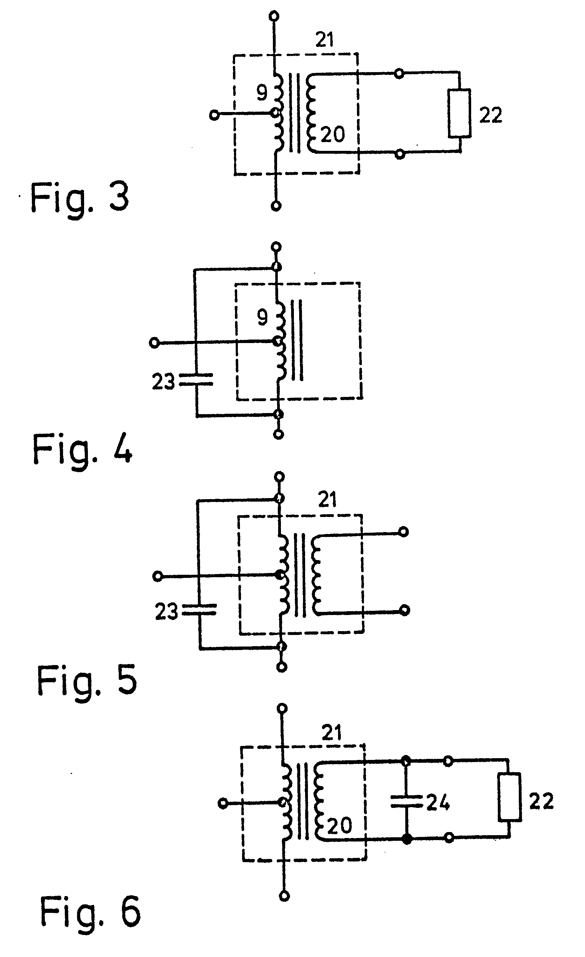

Zur weiteren Veranschaulichung der Erfindung sind in den Figuren 1 bis 6 einige Ausgestaltungen der Schaltungsanordnung und typische Zeitverläufe von Strömen und Spannungen in der Schaltungsanordnung wiedergegeben.

Fig. 1 zeigt das Prinzip der Schaltungsanordnung. Die Verstärkerdreipole 1 und 2 sind in dieser Darstellung beispielhaft als bipolare pnp-Transistoren in Kollektorschaltung angenommen. Es könnten jedoch auch alle anderen bekannten Verstärkerdreipole in jeder der bekannten Grundschaltung verwendet werden. Die Steuerelektroden 3 und 4 sind in dem vorliegenden Beispiel die Basen, und die Ausgangselektroden 5 und 6 die Emitter der beiden Transistoren. Die jeweils dritten Anschlüsse der Verstärkerdreipole, hier die Kollektoren, sind in diesem Beispiel an Masse angeschlossen. Es wird ausdrücklich festgestellt, dass für die Schaltung der Verstärkerdreipole natürlich auch alle bekannten Varianten der Grundschaltungen, zum Beispiel zum Zwecke der Gegenkopplung, denkbar sind. Die in diesem Beispiel gewählte Ausgangsinduktivität 9 dient der magnetischen Zusammenfassung der Ausgangsströme der beiden Verstärkerdreipole. Die Ausgangsinduktivität hat die beiden Endanschlüsse 10 und 11 und den Mittelabgriff 12. Am Mittelabgriff 12 ist die Betriebsspannungsquelle 13 angeschlossen, die die Betriebsspannung $U_B$ liefert. Der Verbraucherwiderstand 22 ist in diesem Beispiel der Ausgangsinduktivität parallelgeschaltet.

Zwischen die Ausgangselektroden 5 und 6 der Verstärkerdreipole 1 und 2 und die Endanschlüsse 10 und 11 der Ausgangsinduktivität 9 ist erfindungsgemäss der Übertrager 14 mit den drei Wicklungen 15, 16 und 17 entsprechend dem im Kennzeichen des Anspruchs 1 angegebenen Anschlussschema geschaltet. Die dritte Wicklung 17 ist mit dem Serienschwingkreis aus der Induktivität 18 und dem Kondensator 19 verbunden. Die Punkte an den Enden der Wicklungen 15 und 16 des Übertragers 14 geben den Wicklungssinn der Wicklungen bezüglich ihrer Anschlüsse wieder. An diesen Punkten ist der entgegengesetzte Wicklungssinn der Wicklungen 15 und 16 zu erkennen.

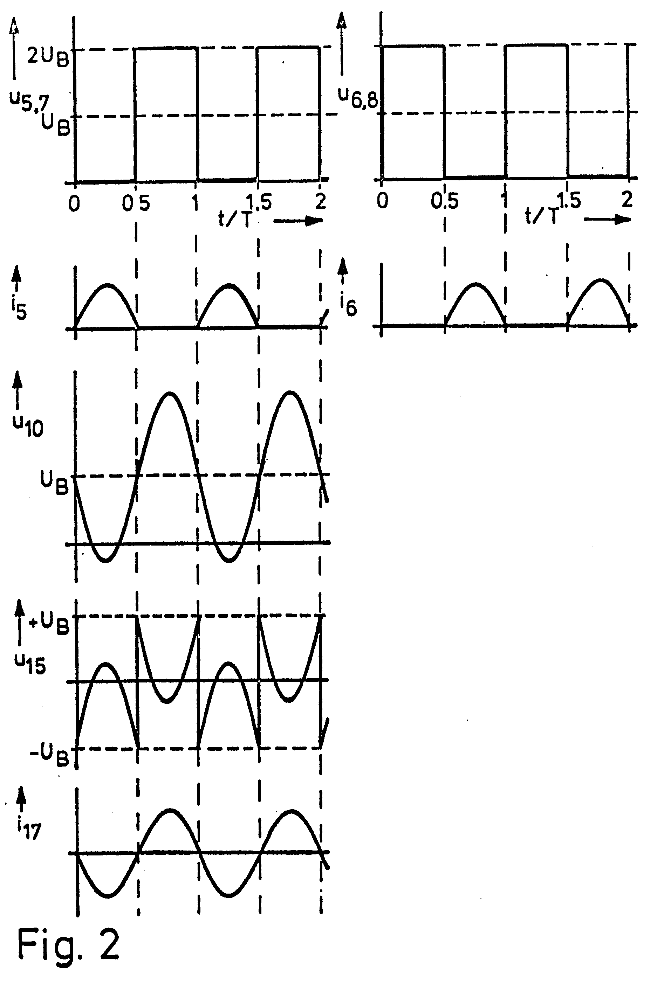

In Figur 2 sind die wichtigsten Ströme und Spannungen aus der Schaltungsanordnung in Fig. 1 wiedergegeben. Dabei ist angenommen, dass die Ansteuerspannungen für die Verstärkerdreipole so gewählt sind, dass die Verstärkerdreipole abwechselnd im Gegentakt für je etwa eine Hälfte der Periodendauer leitend und in der jeweils anderen Hälfte sperrend sind. Wegen der Eigenschaften der Schaltungsanordnung ergeben sich dann an den Verstärkerdreipolen nahezu rechteckförmige Spannungsverläufe, mit den Extremwerten Null und $2^*U_B$. Diese Spannungsverläufe sind in Figur 2 unter Berücksichtigung der Bezeichnung der Anschlusspunkte $u_{5,7}$ für den Verstärkerdreipol 1 und $u_{6,8}$ für den Verstärkerdreipol 2 genannt.

Da die Schaltungsanordnung in der Differenz der Ströme, die durch die Verstärkerdreipole fliessen, nur Komponenten der Grundwelle (mittlere Betriebsfrequenz des Verstärkers) zulässt in den Verstärkerdreipolen aber nur in je einer Hälfte der Periodendauer Strom fliessen kann, sind die Ströme $i_5$ durch den Verstärkerdreipol 1 und $i_6$ durch den Verstärkerdreipol 2 exakte Sinus-Halbwelien. Jeder dieser Ströme geht im Moment des Abschaltens des zugehörigen Verstärkerdreipols automatisch nach Null. Dadurch verlieren die aus der Praxis bekannten Abschaltprobleme an Bedeutung.

Aus einem Vergleich der Strom- und Spannungsverläufe an den beiden Verstärkerdreipolen geht hervor, dass unter diesen idealisierten Verhältnissen keine Verlustleistung entsteht, da an den Verstärkerdreipolen nie Spannung und Strom gleichzeitig von Null verschieden sind.

In Fig. 2 ist auch die am Übertrager 14 entstehende Spannung $u_{15}$ für die Wicklung 15 gezeigt. Eine Fourieranalyse dieses Spannungsverlaufes zeigt, dass in dieser Spannung keine Komponente der Grundwelle enthalten ist. Der Strom $i_{17}$, der durch den Serienresonanzkreis und die Wicklung 17 des Übertragers 14 fliesst, stellt sich als Differenz der Ströme $i_5$ und $i_6$ dar.

Die Ausgangsspannungen $u_{10}$ und $u_{11}$, die zusammen die Spannung am Verbraucherwiderstand 22 ergeben, sind rein sinusförmig.

In den weiteren Figuren sind vorteilhafte Ausgestaltungen der Schaltungsanordnung gezeigt, wie sie in den kennzeichnenden Teilen der Unteransprüche angegeben sind. Es zeigen

Fig. 3 Ergänzung der Ausgangsinduktivität 9 durch eine Sekundärwicklung 20 zu einem Ausgangsübertrager 21 zur Ankopplung des Lastwiderstandes 22

Fig. 4 Ergänzung der Ausgangsinduktivität 9 mit einem Kondensator 23 zu einem Parallelresonanzkreis

Fig. 5 Ergänzung der Primärwicklung eines Ausgangsübertragers 21 mit einem Kondensator 23 zu einem Parallelresonanzkreis

Fig. 6 Ergänzung der Sekundärwicklung eines Ausgangsübertragers 21 mit einem Kondensator 24 zu einem Parallelresonanzkreis.

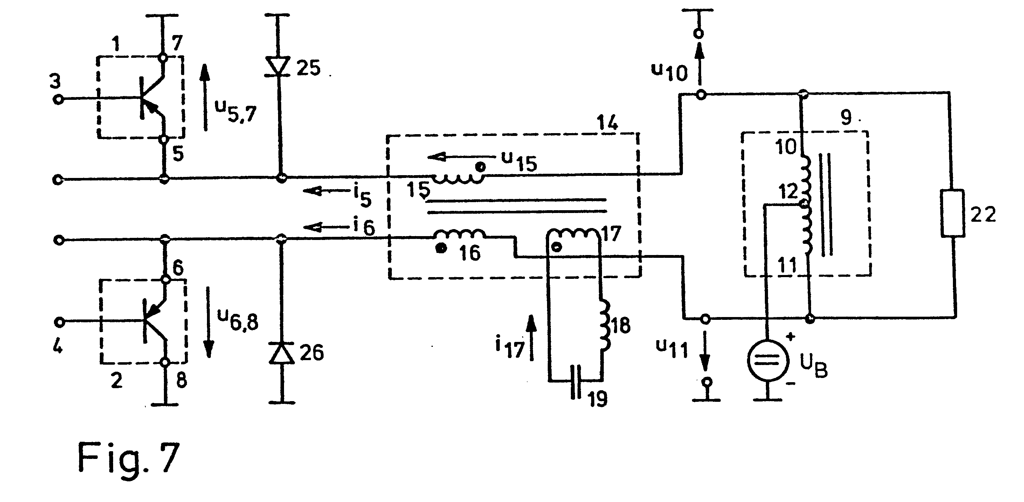

In einer weiteren vorteilhaften Ausgestaltung der Erfindung ist den beiden Verstärkerdreipolen je eine Diode so parallelgeschaltet, dass jede dieser Dioden bei der normalen Polung der Verstärkerdreipole mit der richtigen Betriebsspannungspolarität in Sperrichtung gepolt ist. Diese Ausgestaltung der Erfindung ist in Fig. 7 mit den Dioden 25 und 26 gezeichnet. Solange die Kollektorspannungen der in diesem Beispiel gezeichneten pnp-Transistoren negativ sind, also normale Betriebsspannungspolarität aufweisen, sind die beiden Dioden gesperrt. Der Vorteil dieser Ausgestaltung der Erfindung liegt darin, dass der rein sinus-förmige Differenz-Strom in den beiden ersten Wicklungen 15 und 16 des Übertragers 14 auch dann fliessen kann, wenn die beiden Verstärkerdreipole von den Ansteuerspannungen nicht genau im Gegentakt auf Sperren und Durchlass geschaltet werden. Insbesondere dürfen bei dieser Ausgestaltung der Erfindung zwischen den stromführenden Zeiten der beiden Verstärkerdreipole kurze Zeitabschnitte liegen, in denen beide Verstärkerdreipole gleichzeitig sperrend sind. In diesen Zeitabschnitten wird der von dem Übertrager 14 erzwungene kontinuierliche Strom von den beiden Dioden abgeleitet.

In einer weiteren vorteilhaften Ausgestaltung der Erfindung, die die Verwendung der Dioden 25 und 26 zur Voraussetzung hat, werden die Ansteuerspannungen für die beiden Verstärkerdreipole so ausgebildet, dass die beiden Verstärkerdreipole im Gegentakt abwechselnd jeweils für etwas weniger als eine Hälfte der Periodendauer der momentanen Betriebsfrequenz leitend und in der restlichen Zeit der Periodendauer sperrend sind, wobei sich zwischen den stromführenden Zeiten der beiden Verstärkerdreipole jeweils kurze Zeitabschnitte ergeben, in denen beide Verstärkerdreipole sperren. Bei dieser Ausgestaltung der Erfindung sind die Anforderungen an die Genauigkeit im Zeitverlauf der Ansteuerspannungen besonders niedrig, was zu billigen Lösungen für die Ansteuerschaltung führt. Weiterhin sind bei dieser Ausgestaltung der Erfindung die Anforderungen an das Abschaltverhalten der Verstärkerdreipole weiter reduziert.

**Patentansprüche**

1. Schaltungsanordnung für einen selektiven Gegentaktverstärker, bestehend aus zwei Verstärkerdreipolen (1, 2) gleicher Betriebsspannungspolarität, wobei die Steuerelektroden (3, 4) in bekannter Weise von zwei gegenphasigen Steuerspannungen angesteuert sind, sowie aus einer Ausgangsinduktivität (9) mit Mittelabgriff (12), die in bekannter Weise die magnetische Zusammenfassung der Ausgangsströme der zwei Verstärkerdreipole (1, 2) bewirkt, dadurch gekennzeichnet, dass zwischen den Ausgangselektroden (5 und 6) der Verstärkerdreipole (1 und 2) und den Endanschlüssen (10 und 11) der Ausgangsinduktivität (9) ein Übertrager (14) mit drei Wicklungen (15, 16 und 17) so angeordnet ist, dass von zwei dieser Wicklungen (15 und 16) je eine die Ausgangselektrode je eines Verstärkerdreipoles (1, 2) mit je einem Endanschluss der Ausgangsinduktivität (9) verbindet, und diese beiden Wicklungen (15, 16) entgegengesetzten Wicklungssinn bezogen auf den Anschluss der Ausgangsinduktivität (9) aufweisen, und die dritte Wicklung (17) mit einem Serienschwingkreis aus einer Induktivität (18) und einer Kapazität (19) so beschaltet ist, dass in diesem Serienschwingkreis zusammen mit der Streuinduktivität des Übertragers (14) eine Serienresonanz mit einer Resonanzfrequenz entsteht, die etwa der mittleren Betriebsfrequenz des Verstärkers entspricht.

2. Schaltungsanordnung nach Anspruch 1, dadurch gekennzeichnet, dass die Ausgangsinduktivität (9) zur Leistungsauskopplung an eine Lastimpedanz (22) mit einer Sekundärwicklung (20) zu einem Ausgangsübertrager (21) ergänzt ist.

3. Schaltungsanordnung nach Anspruch 1 oder 2, dadurch gekennzeichnet, dass die Ausgangsinduktivität (9) oder die Primärwicklung (9) des Ausgangsübertragers (21) mit einer Parallelkapazität (23) zu einem Parallelresonanzkreis ergänzt ist, dessen Resonanzfrequenz etwa der mittleren Betriebsfrequenz entspricht.

4. Schaltungsanordnung nach Anspruch 2, dadurch gekennzeichnet, dass die Sekundärwicklung (20) des Ausgangsübertragers (21) mit einer Parallelkapazität (24) zu einem Parallelresonanzkreis ergänzt ist, dessen Resonanzfrequenz etwa der mittleren Betriebsfrequenz des Verstärkers entspricht.

5. Schaltungsanordnung nach Anspruch 3 oder 4, dadurch gekennzeichnet, dass die Kapazität (19), die an die dritte Wicklung (17) des Übertragers (14) angeschlossen ist und die Parallelkapazität (23 oder 24), die der Ausgangsinduktivität (9) oder der Primärwicklung (9) des Ausgangsübertragers (21) oder der Sekundärwicklung (20) des Ausgangsübertragers (21) parallelgeschaltet ist, so dimensioniert sind, dass in ihnen bei der mittleren Betriebsfrequenz des Verstärkers jeweils etwa gleich grosse Blindleistungen umgesetzt werden.

6. Schaltungsanordnung nach einem der Ansprüche 1 bis 5, dadurch gekennzeichnet, dass den beiden Verstärkerdreipolen (1, 2) je eine Diode (25 und 26) so parallelgeschaltet ist, dass jede dieser Dioden bei der normalen Polung der Verstärkerdreipole (1, 2) mit der richtigen Betriebsspannungspolarität in Sperrichtung gepolt ist.

7. Schaltungsanordnung nach einem der Ansprüche 1 bis 6, dadurch gekennzeichnet, dass den beiden Verstärkerdreipolen (1, 2) an ihren Steuerelektroden (3 und 4) solche Ansteuerspannungen zugeführt sind, dass die beiden Verstärkerdreipole (1, 2) im Gegentakt abwechselnd für je etwa eine Hälfte der Periodendauer der momentanen Betriebsfrequenz leitend und in der jeweils anderen Hälfte der Periodendauer sperrend sind.

8. Schaltungsanordnung nach Anspruch 7, dadurch gekennzeichnet, dass die Ansteuerspannungen ungefähr sinusförmigen Verlauf haben.

9. Schaltungsanordnung nach Anspruch 7, dadurch gekennzeichnet, dass die Ansteuerspannungen ungefähr rechteckförmigen Verlauf haben.

10. Schaltungsanordnung nach Anspruch 6, dadurch gekennzeichnet, dass den beiden Verstärkerdreipolen (1, 2) an ihren Steuerelektroden (3 und 4) solche Ansteuerspannungen zugeführt sind, dass die beiden Verstärkerdreipole (1, 2) im Gegentakt abwechselnd jeweils für etwas weniger als eine Hälfte der Periodendauer der momentanen Betriebsfrequenz leitend und in der restlichen Zeit der Periodendauer sperrend sind, derart, dass zwischen den stromführenden Zeiten der beiden Verstärkerdreipole (1, 2) jeweils kurze Zeitabschnitte sind, in denen beide Verstärkerdreipole (1, 2) sperrend sind.

**Claims**

1. Circuit for a selective push-pull amplifier comprising two amplifier tripoles (1, 2) with the same operating voltage polarity, the control electrodes (3, 4) being controlled in known manner by two antiphase control voltages, as well as an output inductor (9) with a centre tap (12), which in known manner brings about the magnetic combination of the output currents of the two amplifier tripoles (1, 2), characterized in that between the output electrodes (5, 6) of amplifier tripoles (1, 2) and the terminals (10, 11) of output inductor (9) is arranged a transformer (14) with three windings (15, 16, 17), in that each of two of these windings (15, 16) connects the output electrode of in each case one amplifier tripole (1, 2) with in each case one terminal of the output inductor (9) and said two windings (15, 16) have an opposite winding direction relative to the connection of the output inductor (9) and the third winding (17) is so wired with a series resonant circuit comprising an inductor (18) and a capacitor (19) that in said series resonant circuit, together with the leakage inductance of transformer (14), there is a series resonance with a resonant frequency approximately corresponding to the average operating frequency of the amplifier.

2. Circuit according to claim 1, characterized in that the output inductor (9) is supplemented by a secondary winding (20) to an output transformer (21) for power decoupling on a load impedance (22).

3. Circuit according to claims 1 or 2, characterized in that the output inductor (9) or the primary winding of the output transformer (21) is supplemented with a parallel capacitor (23) to give a parallel resonant circuit, whose resonant frequency corresponds approximately to the average operating frequency.

4. Circuit according to claim 2, characterized in that the secondary winding (20) of the output transformer (21) is supplemented by a parallel capacitor (24) to give a parallel resonant circuit, whose resonant frequency corresponds approximately to the average operating frequency of the amplifier.

5. Circuit according to claims 3 or 4, characterized in that the capacitor (19) connected to the third winding (17) of transformer (14) and the parallel capacitor (23 or 24) connected and parallel with the output inductor (9) or the primary winding (9) of the output transformer (21) or the secondary winding (20) of the output transformer (21) are so dimensioned that at the average operating frequency of the amplifier in each case approximately equally large reactive powers are transformed therein.

6. Circuit according to one of the claims 1 to 5, characterized in that in each case one diode (25, 26) is so connected in parallel with the two amplifier tripoles (1, 2) that each of said diodes is reverse biased with the correct operating voltage polarity when the amplifier tripoles (1, 2) are normally poled.

7. Circuit according to one of the claims 1 to 6, characterized in that dry voltages are supplied to the control electrodes (3, 4) of the amplifier tripoles (1, 2), which are such that said tripoles (1, 2) in push-pull manner are alternately conductive for approximately half the period of the instantaneous operating frequency and blocked for in each case the other half of the period.

8. Circuit according to claim 7, characterized in that the drive voltages have an approximately sinusoidal course.

9. Circuit according to claim 7, characterized in that the drive voltages have an approximately rectangular course.

10. Circuit according to claim 6, characterized in that drive voltages are supplied to the control electrodes (3, 4) of the two amplifier tripoles (1, 2), which are such that in push-pull operation the two amplifier tripoles (1, 2) are in each case conductive for somewhat less than half the period of the instantaneous operating frequency and are blocked in the remaining part of the period, so that between the current-carrying times of the two amplifier tripoles there are in each case short intervals during which both amplifier tripoles (1, 2) are blocked.

## Revendications

1. Montage pour un amplificateur puch-pull sélectif, comprenant deux tri-pôles amplificateurs (1, 2) ayant la même polarité pour la tension de fonctionnement, les électrodes de commande (3, 4) étant commandés de façon connue par deux tensions de commande en opposition de phase, ainsi que d'une inductance de sortie (9) avec une prise centrale (12) qui assure de façon connue la combinaison magnétique des courants de sortie des deux tri-pôles amplificateurs (1, 2), caractérisé en ce qu'entre les électrodes de sortie (5 et 6) des tri-pôles amplificateurs (1 et 2) et les bornes (10, 11) de l'inductance de sortie (9), il est prévu un organe de transmission (14) à trois enroulements (15, 16, 17), en ce que deux de ces enroulements (15 et 16) relient respectivement l'une des électrodes de sortie de chaque tri-pôle amplificateur (1, 2) à une borne de l'inductance de sortie (9) et en ce que ces deux enroulements (15 et 16) ont un sens d'enroulement opposé par rapport au branchement de l'inductance de sortie (9), et en ce que le troisième enroulement (17) est commuté à un circuit oscillant série composé d'une inductance (18) et d'une capacité (19), en ce que ce circuit oscillant série en liaison avec l'inductance dispersée de l'organe de transmission (14) donne une résonance série ayant une fréquence de résonance qui correspond sensiblement à la fréquence moyenne de fonctionnement de l'amplificateur.

2. Montage selon la revendication 1, caractérisé en ce que pour le découplage de puissance sur une impédance de charge (22) l'inductance de sortie (9) est complétée par un enroulement secondaire (20) pour un organe de transfert de sortie (21).

3. Montage selon la revendication 1 ou 2, caractérisé en ce que l'inductance de sortie (9) ou l'enroulement primaire (9) de l'organe de transfert de sortie (21) est complétée par une capacité en parallèle (23) pour former un circuit résonnant parallèle, dont la fréquence de résonance correspond sensiblement à la fréquence de fonctionnement moyenne.

4. Montage selon la revendication 2, caractérisé en ce que l'enroulement secondaire (20) de l'organe de transfert de sortie (21) est complété par une capacité en parallèle (24) pour former un circuit résonnant parallèle dont la fréquence de résonance correspond sensiblement à la fréquence de fonctionnement moyenne de l'amplificateur.

5. Montage selon la revendication 3 ou 4, caractérisé en ce que la capacité (19) qui est reliée au troisième enroulement (17) de l'organe de transfert (14) et la capacité de parallèle (23 ou 24) qui se trouve en parallèle sur l'inductance de sortie (9) ou sur l'enroulement primaire (9) de l'organe de transfert de sortie (21) ou de l'enroulement secondaire (20) de l'organe de transfert de sortie (21) sont dimensionnés de façon que pour la fréquence de fonctionnement moyenne de l'amplificateur, ils convertissent des puissances réactives ayant sensiblement la même valeur.

6. Montage selon l'une des revendications 1 à 5, caractérisé en ce qu'une diode respective (25 et 26) est branchée en parallèle sur les deux tri-pôles amplificateurs (1, 2) et en ce que chacune de ces diodes est polarisée dans le sens du blocage pour la polarité de tension de fonctionnement correcte, lorsque les tri-pôles amplificateurs (1, 2) sont branchés normalement.

7. Montage selon l'une des revendications 1 à 6, caractérisé en ce que les électrodes de commande (3 et 4) des deux tri-pôles amplificateurs (1, 3) reçoivent des tensions de commande telles que les deux tri-pôles amplificateurs (1, 2) deviennent conducteurs alternativement en opposition de phase pendant sensiblement une moitié de la période de la fréquence de fonctionnement instantanée et sont chaque fois bloqués pendant l'autre moitié de cette période.

8. Montage selon la revendication 7, caractérisé en ce que les tensions de commande ont une forme sensiblement sinusoïdale.

9. Montage selon la revendication 7, caractérisé en ce que les tensions de commande ont un tracé sensiblement rectangulaire.

10. Montage selon la revendication 6, caractérisé en ce que les deux tri-pôles amplificateurs (1, 2) reçoivent sur leurs électrodes de commande (3, 4) des tensions de commande telles que les deux tri-pôles amplificateurs (1, 2) soient conducteurs en opposition de phase, de façon alternée et chaque fois pour une durée sensiblement inférieure à une moitié de la période de la fréquence de fonctionnement instantanée, et qu'ils soient bloqués pendant le reste de la période, de façon qu'entre les périodes pendant lesquelles les deux tri-pôles amplificateurs (1, 2) sont conducteurs, il subsiste chaque fois de courtes durées au cours desquelles les deux tri-pôles amplificateurs (1, 2) sont bloqués.

Fig. 1

Fig. 2

11

Fig. 3

Fig. 4

Fig. 5

Fig. 6

Fig. 7